Europäisches Patentamt

European Patent Office

Office européen des brevets

(19)

(11) Publication number: **0 202 335**
**B1**

(12) **EUROPEAN PATENT SPECIFICATION**

(45) Date of publication of patent specification: **25.10.89**

(21) Application number: **84904170.2**

(22) Date of filing: **15.11.84**

(86) International application number:
**PCT/JP84/00548**

(87) International publication number:
**WO 86/02985 22.05.86 Gazette 86/11**

(51) Int. Cl.⁴: **F 21 Q 3/00, F 21 V 29/00,
G 09 F 13/20, H 01 L 33/00**

(54) **SIGNAL LIGHT UNIT HAVING HEAT DISSIPATING FUNCTION.**

(43) Date of publication of application:
**26.11.86 Bulletin 86/48**

(45) Publication of the grant of the patent:
**25.10.89 Bulletin 89/43**

(84) Designated Contracting States:
**AT BE CH DE FR GB LI LU NL SE**

(56) References cited:
**DE-A-2 449 433**
**DE-A-2 827 523**
**DE-A-3 223 624**
**DE-A-3 236 612**
**JP-U-5 740 963**
**JP-U-52 115 171**
**JP-U-59 119 487**

**PATENTS ABSTRACTS OF JAPAN, vol. 8, no.
74 (E-236)1511r, 6th April 1984; & JP-A-58 222
578 (TOKYO SHIBAURA DENKI K.K.) 24-12-1983**

(73) Proprietor: **JAPAN TRAFFIC MANAGEMENT
TECHNOLOGY ASSOCIATION**
**3, Kojimachi 3-chome**
**Chiyoda-ku Tokyo 102 (JP)**

(73) Proprietor: **Stanley Electric Co., Ltd.**
**9-13, Nakameguro 2-chome**
**Meguro-ku Tokyo 153 (JP)**

(73) Proprietor: **KOITO INDUSTRIES, LTD.**
**100, Maeda-cho Totsuka-ku**
**Yokohama-shi Kanagawa 244 (JP)**

(72) Inventor: **TSUZAWA, Masami 14-15,**
**Minamitsukushino 4-chome**
**Machida-shi**
**Tokyo 194 (JP)**
Inventor: **TOMINAGA, Muneharu 2-47-102,**
**Shiohama 4-chome**
**Ichikawa-shi**
**Chiba 272-01 (JP)**
Inventor: **UCHIYAMA, Yoshinori 16-22,**
**Tsurukawa 3-chome**
**Machida-shi**
**Tokyo 194-01 (JP)**
Inventor: **WAKI, Osamu 1-18, Kitano 1-chome**
**Mitaka-shi**
**Tokyo 181 (JP)**

Note: Within nine months from the publication of the mention of the grant of the European patent, any person may
give notice to the European Patent Office of opposition to the European patent granted. Notice of opposition shall
be filed in a written reasoned statement. It shall not be deemed to have been filed until the opposition fee has been
paid. (Art. 99(1) European patent convention).

Courier Press, Leamington Spa, England.

EP 0 202 335 B1

Inventor: **KATO, Hiroshi**
**3447, Fukaya Ayase-shi**
**Kanagawa 252 (JP)**
Inventor: **MORIKAWA, Tadahiro**
**1184-2, Daigiri Fujisawa-shi**
**Kanagawa 251 (JP)**

(74) Representative: **Fuhlendorf, Jörn**
**Patentanwälte Dreiss, Hosenthien & Fuhlendorf**
**Gerokstrasse 6**
**D-7000 Stuttgart 1 (DE)**

## Description

This invention relates to a signal light box unit which has a signal light that uses as the light source a number of light-emitting diodes (LEDs) arrayed in the form of a plane and which has a function to effectively dissipate heat of large calorie generated inside the light unit.

Conventionally, signal lights have been proposed that use as the light source a number of LEDs arrayed in a plane on a board for the purpose of energy saving. LEDs, however, have a low electricity-to-light conversion efficiency and change most of the electricity to heat despite of their high illumination efficiency and energy saving effectiveness. When used collectively in a large number at a time, therefore, LEDs generate a substantially large calorific power. In addition, LEDs have a negative temperature coefficient of light emission, so that their illumination decreases as the ambient temperature rises; for example, the light is halved at an ambient temperature of 80°C as compared with that at 25°C. To keep a high illumination efficiency of LEDs, therefore, their own temperature must be kept low.

The above mentioned conventional signal light which uses many LEDs has such a fault that the LEDs arrayed as many as meet a prescribed illumination standard as the light source generate a substantially large calorific power when they are energized at the same time. As a result, not only the illumination efficiency of the LEDs will lower but also their service life will shorten, this resulting in a failure as a signal light unit.

In Patent Abstracts of Japan, Vol. 8, No. 74 (e-236) (1511), April 6, 1984, publication No. 58-222 578 (A) a lighting device is disclosed, having a metal electrode substrate in the rectilinearly formed groove of which a plurality of light-emitting diode chips are arranged in a straight line. Apart from the fact that this disclosed lighting device cannot be used for traffic lights because of the arrangement of the LED-chips in only one row, and although it is disclosed that this metal electrode substrate does serve not only as a carrier for the one row of LED-chips but also as a radiator, it seems to be that a radiator constructed in form of a plane plate is able to sufficiently dissipate heat from LEDs if this plate of substrate is provided with an array of LEDs and not only with one straight line of them.

DE—A—32 23 624 discloses a cooling body for electrical components in which a box-shaped housing of the electrical components is provided with a cooling body serving as a cover for the housing and being provided with cooling ribs from which the inner cooling ribs are opposite the electric components and the outer cooling ribs are directed into the environment. In this known device generally refers to electrical components but does not mention LEDs, which obviously even cannot be contained, because the known device refers to a high-frequency-shielded assembly being not necessary for LEDs and because the electrical components are shielded by the cooling body, which wouldn't make any sense with respect to LEDs the emitted light of which has to be visible.

The invention shall solve the problem of providing a signal light box unit that has a heat dissipating function that can dissipate effectively the heat generated inside the LEDs arrayed in a matrix to open air, thus preventing lowering of the light emission efficiency of the LEDs by heat and reverse effects of heat on the signal light.

To this end a signal light box unit having a heat dissipating function of this invention comprises a circuit board on which a plurality of LEDs are arrayed upon a front face of the circuit board in a matrix of several rows and columns; a finned heat sink disposed upon a back face of said board, said heat sink being indirectly connected to the back face of the board; a heat transporting absorber interposed between the said heat sink and the back face of said board. According to an embodiment of the invention the heat sink is placed outside the light box or on the outside surface of the light box. According to another embodiment of the invention an air blower such as fan is installed in the light box.

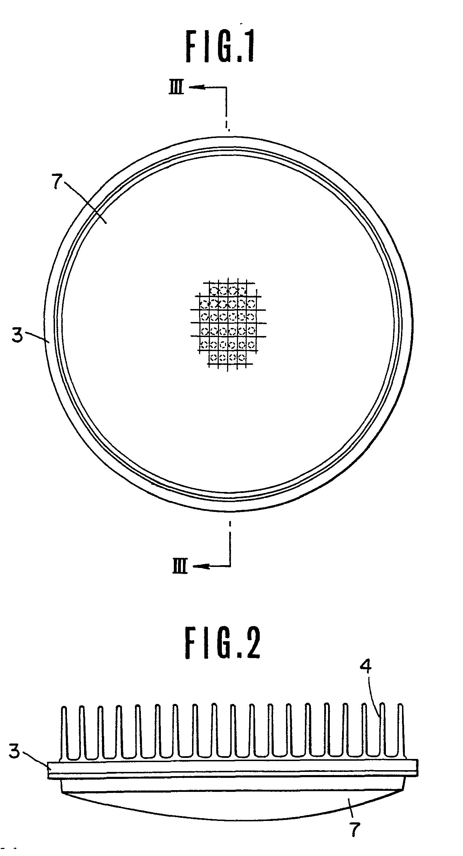

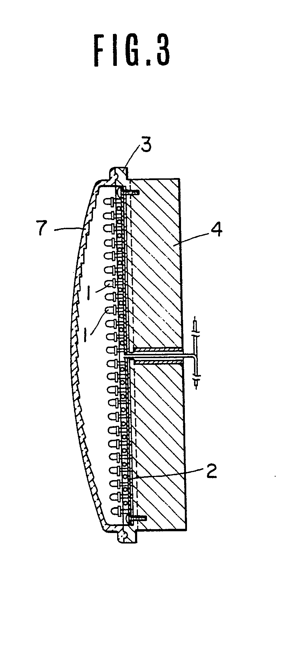

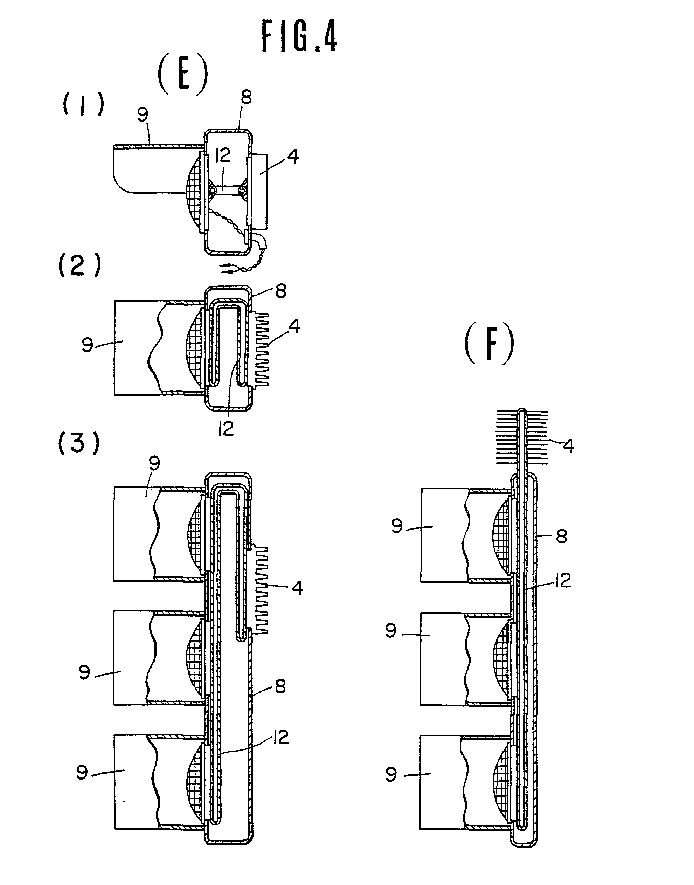

Referring now to the drawings, there is shown a signal light unit embodying this invention which has a heat dissipating function of this invention. Fig. 1 is a top view, Fig. 2 a side view, Fig. 3 a sectional view along lines III—III of Fig. 1, and Fig. 4 E/F different schematic structural representations embodying this invention for use of a signal light unit having a heat dissipating function of this invention as a traffic signal light equipment.

This invention will be better understood from the following description taken in connection with the accompanying drawings.

As shown in Figs. 1 to 4, part 1 is an LED used as the signal light source, part 2 a printed circuit board (PCB) on which many LEDs 1 are arrayed in a plane and connected electrically, and part 3 a board constructed in one piece with a finned heat sink 4 on its back face. On the right side of board 3, an insulation sheet is fitted, and on the sheet the PCB 2 to which many LEDs 1 are fitted in arrays fixed with resin filler. Then, on the right face of board 3, a lens 7 is mounted.

The heat generated by LEDs 1 on the right face of board 3 is led to heat sink 4, provided on the whole back face of board 3 so that the heat can be efficiently dissipated from all the surface of the heat sink. Heat sink 4 is not placed directly on the back face of board 3 but is connected to board 3 through such heat absorber as heat pipes, as described later combination with an air blower such as fan for improvement. Furthermore, heat sink 4 is preferably made of aluminium or any other metal having a good thermal conductivity.

Fig. 4 is embodiment in which a signal light unit of this invention is used as a traffic signal light.

Drawings (E) and (F) in Fig. 4 show the structure in which heat sink 4 is, separately from the back face of board 3, placed on the outside or outer surface of light box 8 to be exposto to open air

and indirectly connected to the back face of board 3 with heat absorber 12, such as of heat pipes, placed between heat sink 4 and board 3, so that a separation between the heat absorbing part and the heat dissipating part will make easy heat insulation or setting of temperature difference for higher heat dissipation effects. Further, in traffic signal light equipment having two or more signal light units, the heat generated by the light units can be, as shown in (3) of drawing (E), gathered into heat absorber 12 common to the light units, and it is also possible to locate heat sink 4 outside light box 8 with the aim of size reduction.

As mentioned above, the signal light unit having a heat dissipating function of this invention is suitable for small-sized energy-saving traffic signal light equipment to be introduced in place of the conventional traffic signal light equipment that is generally installed along the road and which employs incandescent lamps as its light source.

## Claims

1. A signal light box unit having a heat dissipating function which comprises:
a circuit board (2) on which a plurality of LEDs (1) are arrayed upon a front face of the circuit board (2) in a matrix of several rows and columns;
a finned heat sink (4) disposed upon a back face of said board (2), said heat sink (4) being indirectly connected to the back face of the board (2);
a heat transporting absorber (12) interposed between the said heat sink (4) and the back face of said board (2).

2. A signal light unit as claimed in claim 1 in which the heat sink (4) is placed outside the light box (8) or on the outside surface of the light box (8).

3. A signal light unit as claimed in claim 1 or 2 in which an air blower such as fan is installed in the light box (8).

## Patentansprüche

1. Signallichteinheit mit Wärmeabfuhr, die eine Schaltplatte (2), auf deren Vorderfläche eine Vielzahl von LEDs (1) in einer Matrix von mehreren Reihen und Spalten gruppiert ist, einen Lamellenkühlkörper (4), der an der Rückseite der Schaltplatte (2) angeordnet ist, wobei der Kühlkörper (4) mit der Rückfläche der Schaltplatte (2) mittelbar verbunden ist, und einen Wärme transportierenden Absorber (12), der zwischen dem Kühlkörper (4) und der Rückfläche der Schaltplatte (2) angeordnet ist, aufweist.

2. Signallichteinheit nach Anspruch 1, bei der der Kühlkörper (4) außerhalb oder an der Außenfläche des Signallichtgehäuses (8) angeordnet ist.

3. Signallichteinheit nach Anspruch 1 oder 2, bei der ein Luftgebläse, wie bspw. ein Ventilator im Signallichtgehäuse (8) eingebaut ist.

## Revendications

1. Panneau de visualisation lumineux ayant une fonction de dissipation calorique qui comprend une plaque à circuits imprimés (2) sur laquelle une pluralité de DEL (1) sont disposées sur une face frontale de la plaque à circuits (2) dans une matrice de plusieurs rangées et colonnes;
un dissipateur thermique à lames (4), disposé sur une face arrière de ladite plaque (2), ledit dissipateur thermique (4) étant raccordée indirectement à la face arrière de la plaque (2); un absorbeur transporteur thermique (12) interposé entre ledit dissipateur thermique (4) et la face arrière de ladite plaque (2).

2. Panneau de visualisation lumineux selon la revendication 1, dans lequel le dissipateur thermique (4) est placé à l'extérieur de la boite d'éclairage (8) ou sur la face extérieure de la boite d'éclairage (8).

3. Panneau de visualisation lumineux selon la revendication 1 ou 2, dans lequel une soufflerie d'air telle qu'un ventilateur est installée dans la boite d'éclairage (8).

# FIG.1

# FIG.2

# FIG.3

# FIG.4